# EUROPÄISCHE PATENTSCHRIFT

(11) **EP 0 687 070 B1**
(45) Veröffentlichungstag und Bekanntmachung des Hinweises auf die Patenterteilung: **07.01.1998**
(21) Anmeldenummer: 95108386.4
(22) Anmeldetag: 31.05.1995
(51) Int. Cl.: H03K 19/0185, H03K 19/00

(54) **Schaltungsanordnung zur Pegelumsetzung**
Level conversion circuit
Circuit de conversion de niveau

(30) Priorität: 07.06.1994 DE 4419892
(43) Veröffentlichungstag der Anmeldung: 13.12.1995
(73) Patentinhaber: SIEMENS AKTIENGESELLSCHAFT, 80333 München (DE)
(72) Erfinder: Bromm, Christiane, Dipl.-Phys., D-81476 München (DE); Hellwig, Mathias, Dr.-Ing., D-80637 München (DE); Strunz, Roland, Dipl.-Ing., D-81477 München (DE)

(56) Entgegenhaltungen:
- US-A- 4 999 519
- US-A- 5 132 572
- US-A- 5 225 721
- PATENT ABSTRACTS OF JAPAN vol. 18 no. 305 (E-1559) ,10.Juni 1994 & JP-A-60 061838 (NEC CORP) 4.März 1994,

## Beschreibung

Die Erfindung betrifft eine Schaltungsanordnung zur Umsetzung eines unipolaren Signals in zueinander komplementäre Signale, bei der
- eine erste Serienschaltung mit einem ersten Feldeffekttransistor und einem zweiten Feldeffekttransistor gebildet ist, die an ihren einander zugewandten Hauptelektroden miteinander und an ihren der Serienschaltung abgewandten Hauptelektroden mit den Klemmen U_{DD} bzw. U_{SS} einer Betriebsspannungsquelle verbunden sind;
- eine zweite Serienschaltung mit einem dritten Feldeffekttransistor und einem vierten Feldeffekttransistor gebildet ist, die an ihren einander zugewandten Hauptelektroden miteinander und an ihren der Serienschaltung abgewandten Hauptelektroden mit den Klemmen U_{DD} bzw. U_{SS} der Betriebsspannungsquelle verbunden sind;
- die zueinander komplementären Signale zum einen an der Verbindung der Hauptelektroden der Transistoren der ersten Serienschaltung und zum anderen an der Verbindung der Hauptelektroden der Feldeffekttransistoren der zweiten Serienschaltung abgreifbar sind;
- die Steuerelektroden des zweiten Feldeffekttransistors und des vierten Feldeffekttransistors mit dem unipolaren Signal beaufschlagbar sind.

Für die Übertragung von Daten sind hohe Datenraten und einfache Schaltungsstrukturen charakteristisch; demgegenüber sind für die Verarbeitung von Daten niedrige Datenraten und komplexe Schaltungsstrukturen charakteristisch.

Bei einem Betrieb an der oberen Grenze der technisch realisierbaren Datenrate kommt vorzugsweise die ECL(Emitter Coupled Logic)-Schaltüngstechnik zum Einsatz, die eine, allerdings nicht unerhebliche, Verlustleistung mit sich bringt. Komplexe Schaltungsstrukturen werden vorzugsweise in CMOS-Technologie ausgeführt, die gegenüber der ECL-Technologie einen erheblich höheren Integrationsgrad und einen erheblich niedrigeren Grad an Verlustleistung bei einer allerdings deutlich niedrigeren oberen Grenze der möglichen Datenrate aufweist. Die BICMOS(Bipolar Complementary Metal Oxide Silicium)-Schaltungstechnologie vereinigt nun ECL- und CMOS-Schaltungsstrukturen auf einem einzigen Substrat einer monolithisch integrierten Schaltung. An der Schnittstelle zwischen der mit unipolaren Signalen arbeitenden CMOS-Schaltungstechnik und der mit komplementären Signalen arbeitenden ECL-Schaltungstechnik werden Umsetzer benötigt.

Aus der JP 5 199 101 A2 ist eine Schaltungsanordnung zur Umsetzung eines unipolaren Signals in zueinander komplementäre Signale bekannt, bei der eine erste und eine zweite Serienschaltung jeweils mit zwei Feldeffekttransistoren gebildet sind, die an ihren der Serienschaltung abgewandten Hauptelektroden mit den Klemmen U_{DD} bzw. U_{SS} einer Betriebsspannungsquelle verbunden sind, und bei der die zueinander komplementären Signale an den Verbindungen der Hauptelektroden der Feldeffekttransistoren der beiden Serienschaltungen abgreifbar sind. Bei dieser Schaltungsanordnung sind die Steuerelektroden der unmittelbar mit der Klemme U_{SS} verbundenen Feldeffekttransistoren einmal unmittelbar und einmal über einen Inverter mit dem unipolaren Signal beaufschlagt; dieser Inverter erfordert eine gewisse Flache. Die Steuerelektroden der unmittelbar mit der Klemme U_{DD} verbundenen Feldeffekttransistoren sind mit der Verbindung der Hauptelektroden der Feldeffekttransistoren der jeweils anderen Serienschaltung verbunden. Bei dieser Schaltungsanordnung schaltet der über den Inverter angesteuerte Feldeffekttransistor um die Schaltzeit des Inverters verzögert; weiter schalten die unmittelbar mit der Klemme U_{DD} verbundenen Feldeffekttransistoren erst nach Ablauf der Schaltzeit der unmittelbar mit der Klemme U_{SS} verbundenen Feldeffekttransistoren. Die sich einander aufsummierenden Schaltzeiten begrenzen die mit dieser Schaltungsanordnung insgesamt erzielbare Schaltgeschwindigkeit.

Der Erfindung liegt das Problem zugrunde, eine Schaltungsanordnung mit geringem Flächenbedarf für einen Pegelumsetzer anzugeben, der einerseits Daten an der oberen Grenze der technisch realisierbaren Datenrate bei einer niedrigen Verlustleistung umzusetzen vermag und der andererseits in Betriebspausen bezüglich der Eigenstromaufnahme abschaltbar ist.

Das Problem wird bei einer eingangs umrissenen Schaltungsanordnung dadurch gelöst, daß
- die Steuerelektroden des zweiten Feldeffekttransistors und des vierten Feldeffekttransistors unmittelbar miteinander verbunden sind ;
- der erste Transistor und der dritte Transistor an ihren Steuerelektroden mit einem Signal zur Abschaltung der Schaltungsanordnung beaufschlagbar sind.

Die erfindungsgemäße Schaltungsanordnung, die mit nur vier Feldeffekttransistoren gebildet ist, weist neben einem niedrigen Aufwand für die erforderliche Fläche den Vorteil von sehr kurzen Flankenanstiegszeiten und damit sehr kleinen Signallaufzeiten bei einer niedrigen Leistungsaufnahme auf.

Weitere Weiterbildungen der erfindungsgemäßen Schaltungsanordnung betreffen die Kompensation von unterschiedlichen Flankenanstiegszeiten und/oder unterschiedlichen Pegelhüben der beiden Serienschaltungen.

Eine besonders vorteilhafte Anwendung der erfindungsgemäßen Schaltungsanordnung ergibt sich in einem Koppelfeldbaustein, bei dem eine Vielzahl von Umsetzern zum Einsatz kommt und demgemäß sich der niedrige Flächenbedarf und die niedrige Leistungsaufnahme besonders vorteilhaft bemerkbar machen.

Die Erfindung wird nun als Ausführungsbeispiel in zum Verständnis erforderlichem Umfang anhand einer Figur naher beschrieben.

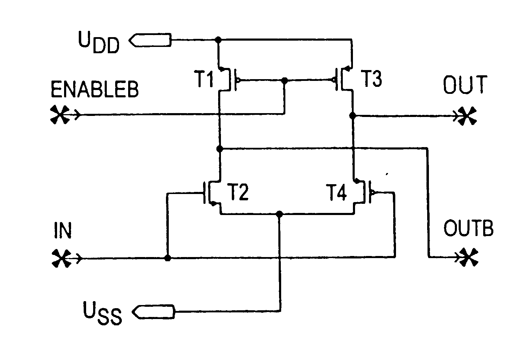

- Fig. 1: zeigt die erfindungsgemaße Schaltungsanordnung des Pegelumsetzers.

Ein erster Transistor T1 und ein zweiter Transistor T2 sind durch Verbindung jeweils einer Hauptelektrode zu einer ersten Serienschaltung verbunden. Die der Serienschaltung abgewandte Hauptelektrode des ersten Transistors ist mit der das hohe Potential führenden Klemme U_{DD} einer nicht naher dargestellten Betriebsspannungsquelle und die der Serienschaltung abgewandte Hauptelektrode des zweiten Transistors mit der das niedrige Potential führenden Klemme U_{SS} der Betriebsspannungsquelle verbunden. Ein dritter Transistor T3 und ein vierter Transistor T4 bilden durch Verbindung jeweils einer Hauptelektrode eine zweite Serienschaltung. Die der Serienschaltung abgewandte Hauptelektrode des dritten Transistors T3 ist mit der Klemme U_{DD} und die der Serienschaltung abgewandte Hauptelektrode des vierten Transistors T4 mit der Klemme U_{SS} verbunden. Die Verbindung der Transistoren der zweiten Serienschaltung und die Verbindung der Transistoren der ersten Serienschaltung sind mit den Ausgangsklemmen OUT bzw. OUTB der Schaltungsanordnung verbunden. Die Steuerelektroden des zweiten Transistors und des vierten Transistors sind einerseits miteinander verbunden und andererseits mit der Eingangsklemme IN der Schaltungsanordnung verbunden. Die Steuerelektroden des ersten Transistors und des dritten Transistors sind einerseits miteinander verbunden und andererseits mit der Eingangsklemme ENABLEB der Schaltungsanordnung verbunden. Der erste Transistor, der dritte Transistor und der vierte Transistor sind durch Feldeffekttransistoren vom selbstsperrenden p-Kanal-Typ gegeben. Der zweite Transistor ist durch einen Feldeffekttransistor vom selbstsperrenden n-Kanal-Typ gegeben. Die Schaltungsanordnung ist also ausschließlich mit CMOS(Complementary Metal Oxide Silicium)- Transistoren aufgebaut.

Für den Betrieb der Schaltungsanordnung als Pegelumsetzer wird die Eingangsklemme ENABLEB annähernd auf das Potential oder auf das Potential selbst der Klemme U_{SS} gelegt, wodurch der erste Transistor und der dritte Transistor jeweils quasi als ohmscher Widerstand betrieben werden.

Der Eingangsklemme IN möge ein von einer nicht naher dargestellten und in CMOS-Technologie realisierten Schaltungsanordnung abgegebenes Signal zugeführt sein. Weist die Eingangsklemme IN einen hohen Signalpegel auf, so werden der zweite Transistor in den leitenden Zustand und der vierte Transistor in den gesperrten Zustand versetzt, wodurch die Ausgangsklemme OUTB an das Potential der Klemme U_{SS} angenähert wird und die Ausgangsklemme OUT im wesentlichen das Potential der Klemme U_{DD} annimmt. Weist hingegen die Eingangsklemme IN einen niedrigen Signalpegel auf, so werden der zweite Transistor in den gesperrten Zustand und der vierte Transistor in den leitenden Zustand versetzt, wodurch die Ausgangsklemme OUTB annähernd das Potential der Klemme U_{DD} annimmt und die Ausgangsklemme OUT an das Potential der Klemme. U_{SS} angenähert wird.

Im folgenden wird nun die dem Fachmann geläufige Maßnahme zugrunde gelegt, durch flächenmäßige Dimensionierung eines Transistors den Durchlaßwiderstand und auch die Anstiegs- bzw. Abfallzeit eines Transistors festzulegen. Für eine Verwendung der vorliegenden Schaltungsanordnung als CMOS/ECL(Emitter Coupled Logic)-Umsetzer möge durch flächenmäßige Dimensionierung der Durchlaßwiderstand der Transistoren derart festgelegt sein, daß bei einem Pegelwechsel an der Eingangsklemme IN an den Ausgangsklemmen OUT bzw. OUTB ein Pegelhub von etwa 240 mv erfolgt.

In Tabelle 1 sind die mit der erfindungsgemäßen Schaltungsanordnung erzielten Flankenanstiegszeiten angegeben.

**Tabelle 1**

| Signale | Flankenanstiegszeit (20/80) | |
|---|---|---|
| | nc/ps | wc/ps |
| OUT | 52 | 60 |
| OUTQ | 90 | 116 |

Die mit der Ausgangsklemme OUT verbundene zweite Serienschaltung weist im Normalbetriebsfall (nc) eine Flankenanstiegszeit von 52 ps und unter ungünstigsten Bedingungen (wc) eine Flankenanstiegszeit von 60 ps auf. Die mit der Ausgangsklemme OUTB verbundene erste Serienschaltung weist unter normalen Betriebsbedingungen (nc) eine Flankenanstiegszeit von 90 ps und unter ungünstigsten Bedingungen (wc) eine Flankenanstiegszeit von 116 ps auf. Wie weiter oben bereits darauf hingewiesen wurde, können die beiden Serienschaltungen durch flächenmäßige Dimensionierung ihrer Transistoren auf gleiche Flankenanstiegszeiten gebracht sein.

Tabelle 2 gibt Werte für die Verlustleistung der erfindungsgemäßen Schaltungsanordnung unter Normalbedingungen (nc) und unter ungünstigsten Bedingungen (wc) an.

**Tabelle 2**

| CMOS/ECL-Wandlung | nc/mW | wc/mW |
|---|---|---|
| Verlustleistung | 1,25 | 1,66 |

Die Verlustleistung der erfindungsgemäßen Schaltungsanordnung beträgt also typischerweise im Normalbetrieb 1,25 mW und unter ungünstigsten Bedingungen 1,66 mW. Diese Werte beziehen sich auf einen Betrieb des Wandlers mit einem Eingangssignal mit bis zu 500 MBit/s.

Die erfindungsgemäße Schaltungsanordnung kann in einer in BICMOS(Bipolare Complementary Metal Oxide Silicium)-Technologie realisierten Schaltungsumgebung eingesetzt sein. Bei der BICMOS-Technologie sind bekanntlich CMOS-Schaltungsstrukturen zusammen mit ECL-Schaltungsstrukturen auf einem einzigen Substrat monolithisch integriert. In der Fertigung von integrierten Schaltungen wird als eine Maßnahme zur Aussortierung mangelhafter integrierter Schaltungen die sogenannte Leckstrommessung angewendet. Bei der Leckstrommessung wird die zu prüfende integrierte Schaltung mit der Betriebsspannung beaufschlagt und der von der Schaltung aufgenommene Strom gemessen. Überschreitet der gemessene Strom einen vorgegebenen Grenzwert, so wird auf einen Mangel geschlossen und die betroffene integrierte Schaltung aussortiert. Bei Anwendung dieser Prüfmethode an in BICMOS-Technologie realisierten Schaltungen macht es sich nachteilig bemerkbar, wenn in einzelnen Schaltungsteilen Leckströme auftreten, die in einer Großenordnung sind wie mögliche mangelbedingte Ströme in anderen Schaltungsteilen. Zur Vermeidung dieser Problematik kann die erfindungsgemäße Schaltungsanordnung über ein der Eingangsklemme ENABLEB zugeführtes Signal mit einem hohen Pegel leckstromfrei geschaltet werden.

## Patentansprüche

1. Schaltungsanordnung zur Umsetzung eines unipolaren Signales (IN) in zueinander komplementäre Signale (OUT, OUTB), bei der
- eine erste Serienschaltung mit einem ersten Feldeffekttransistor (T1) und einem zweiten Feldeffekttransistor (T2) gebildet ist, die an ihren einander zugewandten Hauptelektroden miteinander und an ihren der Serienschaltung abgewandten Hauptelektroden mit den Klemmen U_{DD} bzw. U_{SS} einer Betriebsspannungsquelle verbunden sind;
- eine zweite Serienschaltung mit einem dritten Feldeffekttransistor (T3) und einem vierten Feldeffekttransistor (T4) gebildet ist, die an ihren einander zugewandten Hauptelektroden miteinander und an ihren der Serienschaltung abgewandten Hauptelektroden mit den Klemmen U_{DD} bzw. U_{SS} der Betriebsspannungsquelle verbunden sind;
- die zueinander komplementären Signale zum einen an der Verbindung der Hauptelektroden der Transistoren der ersten Serienschaltung und zum anderen an der Verbindung der Hauptelektroden der Feldeffekttransistoren der zweiten Serienschaltung abgreifbar sind;
- die Steuerelektroden des zweiten Feldeffekttransistors und des vierten Feldeffekttransistors mit dem unipolaren Signal beaufschlagbar sind;
**dadurch gekennzeichnet**, daß
- die Steuerelektroden des zweiten Feldeffekttransistors und des vierten Feldeffekttransistors unmittelbar miteinander verbunden sind ;
- der erste Transistor und der dritte Transistor an ihren Steuerelektroden mit einem Signal zur Abschaltung der Schaltungsanordnung beaufschlagbar sind.

2. Schaltungsanordnung nach Anspruch 1
**dadurch gekennzeichnet,**
daß der erste Transistor, der dritte Transistor und der vierte Transistor vom selbstsperrenden p-Kanal-Typ sind und der zweite Transistor vom selbstsperrenden n-Kanal-Typ ist.

3. Schaltungsanordnung nach einem der vorstehenden Ansprüche,
**dadurch gekennzeichnet,**
daß die der jeweiligen Serienschaltung abgewandten Hauptelektroden des ersten Transistors bzw. des dritten Transistors mit der das hohe Potential führenden Klemme U_{DD} und die der jeweiligen Serienschaltung abgewandten Hauptelektroden des zweiten Transistors und des vierten Transistors mit dem das niedrige Potential führenden Klemme U_{SS} verbunden sind.

4. Schaltungsanordnung nach einem der vorstehenden Ansprüche,
**dadurch gekennzeichnet,**
daß mögliche Abweichungen bezüglich der Signalanstiegszeiten zwischen den beiden Serienschaltungen durch Auslegung hinsichtlich der Fläche der einzelnen Transistoren kompensiert sind.

5. Schaltungsanordnung nach einem der vorstehenden Ansprüche,
**gekennzeichnet durch**
eine in CMOS (Complementary Metal Oxide Silicium)-Technologie realisierte Schaltungsanordnung.

6. Verwendung einer Schaltungsanordnung nach einem der vorstehenden Ansprüche in einem Koppelfeldbaustein.

## Claims

1. Circuit arrangement for converting a unipolar signal (IN) into mutually complementary signals (OUT, OUTB), in which
- a first series circuit is formed by a first field-effect transistor (T1) and a second field-effect transistor (T2), which are connected to one another at their main electrodes which face one another and are connected to the terminals U_{DD} and U_{SS}, respectively, of an operating voltage source at their main electrodes which are remote from the series circuit;
- a second series circuit is formed by a third field-effect transistor (T3) and a fourth field-effect transistor (T4), which are connected to one another at their main electrodes which face one another and are connected to the terminals U_{DD} and U_{SS}, respectively, of the operating voltage source at their main electrodes which are remote from the series circuit;
- the mutually complementary signals can be picked off on the one hand at the connection between the main electrodes of the transistors of the first series circuit and, on the other hand, at the connection between the main electrodes of the field-effect transistors of the second series circuit;
- the unipolar signal can be applied to the control electrodes of the second field-effect transistor and of the fourth field-effect transistor;
characterized in that
- the control electrodes of the second field-effect transistor and of the fourth field-effect transistor are connected directly to one another;
- a signal for disconnecting the circuit arrangement can be applied to the control electrodes of the first transistor and of the third transistor.

2. Circuit arrangement according to Claim 1, characterized in that the first transistor, the third transistor and the fourth transistor are of the normally off p-channel type, and the second transistor is of the normally off n-channel type.

3. Circuit arrangement according to one of the preceding claims, characterized in that those main electrodes of the first transistor and of the third transistor which are remote from the respective series circuit are connected to the terminal U_{DD} carrying the high potential, and those main electrodes of the second transistor and of the fourth transistor which are remote from the respective series circuit are connected to the terminal U_{SS} carrying the low potential.

4. Circuit arrangement according to one of the preceding claims, characterized in that possible deviations as regards the signal rise times between the two series circuits are compensated for by a design with regard to the area of the individual transistors.

5. Circuit arrangement according to one of the preceding claims, characterized by a circuit arrangement which is realized using CMOS (Complementary Metal Oxide Silicon) technology.

6. Use of a circuit arrangement according to one of the preceding claims in a switching matrix module.

## Revendications

1. Montage pour la conversion d'un signal unipolaire (IN) en des signaux complémentaires l'un de l'autre (OUT, OUTB), dans lequel
- un premier circuit série est formé d'un premier transistor à effet de champ (T1) et d'un second transistor à effet de champ (T2) qui sont reliés ensemble par leurs électrodes principales proches l'une de l'autre et qui sont reliés respectivement aux bornes UDD et USS d'une source de tension de fonctionnement par leurs électrodes principales éloignées du circuit série ;
- un second circuit série est formé d'un troisième transistor à effet de champ (T3) et d'un quatrième transistor (T4) à effet de champ qui sont reliés ensemble par leurs électrodes principales proches l'une de l'autre et qui sont reliés respectivement aux bornes UDD et USS de la source de tension de fonctionnement par leurs électrodes principales éloignées du circuit série ;
- les signaux complémentaires l'un de l'autre peuvent être prélevés d'une part à la jonction des électrodes principales des transistors du premier circuit série et d'autre part à la jonction des électrodes principales des transistors à effect de champ du second circuit série ;
- les électrodes de commande du second transistor à effet de champ et du quatrième transistor à effet de champ peuvent recevoir le signal unipolaire ;
caractérisé par le fait que
- les électrodes de commande du second transistor à effet de champ et du quatrième transistor à effet de champ sont reliées directement l'une à l'autre ;
- le premier transistor et le troisième transistor peuvent recevoir à leurs électrodes principales un signal pour la coupure du montage.

2. Montage selon la revendication 1,
caractérisé par le fait que
le premier transistor, le troisième transistor et le quatrième transistor sont des transistors à canal de type p autobloquants et le second transistor est un transistor à canal de type n autobloquant.

3. Montage selon l'une des revendications précédentes,
caractérisé par le fait que
les électrodes principales, éloignées du circuit série respectif, du premier transistor et du troisième transistor sont reliées à la borne UDD conduisant le potentiel haut et les électrodes principales, éloignées du circuit série respectif, du second transistor et du quatrième transistor sont reliées à la borne USS conduisant le potentiel bas.

4. Montage selon l'une des revendications précédentes,
caractérisé par le fait que
des écarts possibles des temps de croissance de signaux entre les deux circuits série sont compensés par le dimensionnement de la surface des différents transistors.

5. Montage selon l'une des revendications précédentes, caractérisé par un montage mis en oeuvre en technologie CMOS (Complementary Metal Oxide Silicium).

6. Utilisation d'un montage selon l'une des revendications précédentes dans un composant de réseau de connexion.
